# FASCICULE DE BREVET EUROPEEN

(11) **EP 1 850 488 B1**
(45) Date de publication et mention de la délivrance du brevet: **07.10.2009**
(21) Numéro de dépôt: 06008615.4
(22) Date de dépôt: 26.04.2006
(51) Int. Cl.: H04B 1/04, H04B 17/00, H04B 1/30

(54) **Procédé de détection d'imperfections de la voie d'émission d'un dispositif radiofréquence du type à conversion directe et dispositif correspondant**
Verfahren zur Detektion von Verzerrung in einem Sendepfad eines Direktkonversionshochfrequenzgerätes und Vorrichtung hierzu
Method for detecting transmit path distortions in a direct conversion radiofrequency device and corresponding device

(43) Date de publication de la demande: 31.10.2007
(73) Titulaire: STMicroelectronics N.V., 1118 BH Schiphol Airport Amsterdam (NL); STMicroelectronics SA, 92120 Montrouge (FR)
(72) Inventeur: Conti, Frédéric, 74100 Ambilly (FR); Duez, Frédéric, 38100 Grenoble (FR); Roux, Jocelyn, 38570 Hurtières (FR)
(74) Mandataire: Zapalowicz, Francis

(56) Documents cités:
- WO-A-03/043206
- US-A1- 2005 047 494
- US-A1- 2005 181 749
- US-B1- 6 298 096

## Description

L'invention concerne les systèmes de communication sans fil, et plus particulièrement la détection d'imperfections de la voie d'émission d'un dispositif radiofréquence sans fil du type à conversion directe.

L'invention s'applique avantageusement mais non limitativement aux dispositifs opérant selon la norme à bande ultra large (UWB : Ultra Wide Band) basée sur un multiplexage multibandes par répartition orthogonale de fréquences (Multiband OFDM : Multiband Orthogonal Frequency-Division Multiplexing). Une telle norme est connue sous la dénomination MBOA (Multiband OFDM Alliance).

Le multiplexage par répartition orthogonale de fréquences (OFDM) est un procédé de modulation numérique dans lequel un signal est divisé en plusieurs canaux à bande étroite (sous-porteuses) ayant des fréquences différentes.

Un récepteur à conversion directe, encore appelé récepteur à fréquence intermédiaire nulle (récepteur « ZIF ») possède une architecture homodyne et convertit (transpose) le signal reçu, par exemple un signal radiofréquence UWB OFDM, directement en bande de base, c'est-à-dire directement autour de la fréquence 0 Hz.

De même, un émetteur à conversion directe convertit (transpose) le signal en bande de base directement en un signal radiofréquence.

Les intérêts d'une telle architecture à structure homodyne sont les éliminations du traitement de l'image et des filtres de fréquences intermédiaires. De ce fait, un tel dispositif (émetteur/récepteur) est plus facile à intégrer qu'un dispositif hétérodyne dans lequel la conversion descendante correspondante en bande de base et la conversion montante dans le domaine radiofréquence s'effectuent par le biais d'une ou de plusieurs transpositions intermédiaires à des fréquences intermédiaires.

Cependant, de tels dispositifs à conversion directe, en particulier les émetteurs, sont sujets à des imperfections ayant des effets sur la qualité du spectre du signal transmis. Ces imperfections sont en particulier dues à des puissances parasites transmises au niveau de l'antenne en raison des fuites d'oscillateur local et à une fréquence image non désirée au niveau de l'antenne provoquée par un désappariement en phase et/ou en gain des deux voies I et Q de la chaîne d'émission.

WO 03/043206 décrit un dispositif d'émission, en particulier pour téléphone mobile, comportant des moyens de compensation minimisant les produits d'intermodulation.

Il est important de pouvoir détecter ces imperfections de la voie d'émission, notamment en termes de puissances parasites émises au niveau de l'antenne.

Traditionnellement, un détecteur radiofréquence est inséré à la sortie de l'étage amplificateur de puissance de la voie d'émission pour mesurer la puissance radiofréquence et l'enveloppe du signal émis. Le signal ainsi mesuré est numérisé et envoyé à l'étage numérique de traitement en bande de base qui traite les données correspondantes et effectue les corrections nécessaires.

Or, lorsque les normes imposent un faible niveau de puissance maximum à l'émission (incluant la puissance du signal utile et la puissance parasite résultant des imperfections de la voie d'émission), comme c'est le cas pour la norme MBOA (selon laquelle la puissance ne doit pas dépasser -41 dBm par MHz, c'est-à-dire -14 dBm pour une bande de 528 MHz), les détecteurs radiofréquence classiques, comme par exemple les détecteurs de niveau quadratique (détecteurs RMS : Root Mean Square) réalisés sous forme intégrée, ne permettent pas de réaliser cette détection de puissance dans toute la bande radiofréquence du signal, en particulier lorsque le signal radiofréquence est faible.

L'invention vise à apporter une solution à ce problème.

Différents aspects et modes de mise en oeuvre et de réalisation de l'invention sont définis par les revendications.

Selon un aspect de l'invention, il est proposé un procédé de détection d'imperfections de la voie d'émission d'un dispositif radiofréquence du type à conversion directe comportant un étage de transposition de fréquence d'émission apte à transposer un signal en bande de base dont la fréquence se situe dans une plage initiale de fréquences, (par exemple la plage de 0 à 264 MHz) en un signal radiofréquence.

Le procédé comprend au moins une première phase de détection dans laquelle on génère un signal d'étalonnage en bande de base ayant une fréquence d'étalonnage choisie dans ladite plage initiale, on multiplie par lui-même (c'est-à-dire que l'on élève au carré) un signal d'étalonnage transposé issu dudit signal d'étalonnage en bande de base, ce signal d'étalonnage transposé étant prélevé en aval de l'étage de transposition de fréquence d'émission de façon à obtenir un signal transposé élevé au carré, on filtre le signal transposé élevé au carré de façon à en éliminer les composantes radiofréquence, et on mesure au moins le niveau de la composante fréquentielle du signal filtré ayant ladite fréquence d'étalonnage.

Ainsi, selon l'invention, l'élévation au carré du signal transposé en combinaison avec un filtrage du signal de façon à éliminer les composantes radiofréquence, permet de mesurer de façon très simple le niveau de la composante fréquentielle du signal filtré qui a la fréquence d'étalonnage, ce niveau de cette composante fréquentielle étant représentatif de certaines imperfections de la voie d'émission, en particulier des fuites d'oscillateur local.

Et, une telle détection, bien qu'elle puisse s'appliquer à tout signal radiofréquence quel que soit son niveau d'émission, est particulièrement bien adaptée aux signaux radiofréquence ayant un faible niveau d'émission admissible, comme c'est le cas en particulier pour certains signaux UWB.

Il est en outre avantageux que la première phase de détection comporte en outre une mesure de niveau de la composante fréquentielle du signal filtré ayant le double de ladite fréquence d'étalonnage.

Ceci permet également de détecter un autre type d'imperfection de la voie d'émission telle qu'une déviation par rapport à la constellation idéale provoquée en particulier par les désappariements en gain et/ou en phase des voies I et Q de la voie d'émission.

La voie d'émission comporte généralement un étage amplificateur de puissance disposé en aval de l'étage de transposition de fréquence.

Selon un mode de mise en oeuvre, on peut prélever le signal d'échantillonnage transposé, en aval de l'étage amplificateur de puissance. Ceci permet de manière avantageuse, de prendre en compte également directement les influences de l'étage amplificateur de puissance. Mais, il serait également possible de prélever le signal d'échantillonnage en amont de l'étage amplificateur de puissance en tenant compte des gains théoriques de l'étage amplificateur de puissance.

Cela étant, prélever le signal d'échantillonnage transposé en amont de l'étage amplificateur de puissance permet lorsque l'étage amplificateur de puissance est désactivé, d'avoir une mesure plus précise du niveau de la composante fréquentielle du signal filtré ayant le double de la fréquence d'échantillonnage car une telle mesure nécessite d'émettre le signal d'échantillonnage en bande de base avec un plus fort niveau que celui nécessaire pour la mesure de la composante fréquentielle ayant simplement la fréquence d'étalonnage.

Cela étant, il est tout à fait possible de façon à mesurer très précisément le niveau de la composante fréquentielle à la fréquence d'étalonnage f1 et le niveau de la composante fréquentielle à la fréquence 2f1, lorsque le procédé comporte en outre une deuxième phase de détection, effectuée à un instant différent de la première phase de détection.

Au cours de cette deuxième phase de détection, on désactive l'étage amplificateur de puissance, on génère un signal d'étalonnage en bande de base ayant une fréquence d'étalonnage choisie dans la plage initiale, on prélève le signal d'échantillonnage transposé en amont de l'étage amplificateur de puissance, on le multiplie par lui-même et on filtre le signal transposé élevé au carré de façon à en éliminer les composantes radiofréquences et on mesure au moins le niveau de la composante fréquentielle du signal filtré ayant le double de ladite fréquence d'étalonnage.

En d'autres termes, bien qu'il soit possible de mesurer dans chacune des phases de détection, à la fois le niveau de la composante f1 et le niveau de la composante 2f1, on utilisera préférentiellement la première phase de détection, c'est-à-dire l'élévation au carré du signal prélevé en aval de l'étage d'amplificateur de puissance pour mesurer le niveau de la composante f1 du signal filtré, et on utilisera préférentiellement la deuxième phase de détection, c'est-à-dire celle où l'on élève au carré le signal prélevé en amont de l'étage amplificateur de puissance, pour mesurer le niveau de la composante fréquentielle 2f1.

Les deux phases de détection sont en fait analogues et diffèrent simplement par l'endroit où l'on prélève le signal transposé à élever au carré. En outre, pour la deuxième phase de détection, on désactive l'étage amplificateur de puissance. Enfin, on n'effectue pas ces deux phases de détection en même temps.

Selon un mode de mise en oeuvre de l'invention, la mesure du niveau d'une composante fréquentielle du signal filtré comporte une transformée du signal filtré dans le domaine fréquentiel, par exemple par une transformée de Fourier, et une mesure de niveau des échantillons correspondant à ladite composante fréquentielle, par exemple en utilisant une détection quadratique (détection RMS), ce qui est aisément possible puisqu'on se situe dans le domaine fréquentiel de la bande de base.

De façon à couvrir au moins en partie toute la bande de base, on peut générer, dans chaque phase de détection, plusieurs signaux d'étalonnage ayant des fréquences d'étalonnage différentes choisies dans la plage de fréquences initiale (0-264 MHz par exemple) et on mesure alors le niveau des composantes fréquentielles correspondantes.

On choisira de préférence un signal d'étalonnage ayant une fréquence pure en étant au maximum exempt d'harmonique. On pourra par exemple utiliser un signal sinusoïdal.

Le dispositif radiofréquence comporte également généralement une voie de réception comportant un filtre passe-bas disposé en aval d'un étage de transposition de fréquence de réception. On utilise avantageusement ce filtre passe-bas pour filtrer le signal transposé élevé au carré et prélevé sur la voie d'émission.

On effectue avantageusement chaque phase de détection à la mise sous tension du dispositif.

Cela étant, on peut effectuer chaque phase de détection au cours de périodes d'inactivité en émission et réception du dispositif, en particulier lors de changements de température.

Bien entendu, dans tout ce qui vient d'être mentionné, le mot « chaque » affecté à la phase de détection, concerne l'une et/ou l'autre des phases de détection.

Selon un autre aspect de l'invention, il est également proposé un dispositif radiofréquence du type à conversion directe, comportant un étage de transposition de fréquence d'émission apte à transposer un signal en bande de base dont la fréquence se situe dans une plage initiale de fréquences en un signal radiofréquence.

Selon une caractéristique générale de cet autre aspect de l'invention, le dispositif comprend au moins des premiers moyens activables de détection comportant
des premiers moyens de génération apte à générer un signal d'étalonnage en bande de base ayant une fréquence d'étalonnage choisie dans ladite plage initiale,
des premiers moyens de multiplication possédant ses deux entrées connectées en aval de l'étage de transposition de fréquence d'émission de façon à délivrer un signal transposé élevé au carré issu dudit signal d'étalonnage en bande de base,
des premiers moyens de filtrage aptes à filtrer le signal transposé élevé au carré de façon à en éliminer les composantes radiofréquences, et
des premiers moyens de mesure aptes à mesurer au moins le niveau de la composante fréquentielle du signal filtré ayant ladite fréquence d'étalonnage.

Selon un mode de réalisation, les premiers moyens de mesure sont aptes en outre à mesurer le niveau de la composante fréquentielle du signal filtré ayant le double de ladite fréquence d'étalonnage.

Selon un mode de réalisation de l'invention dans lequel la voie d'émission comporte un étage amplificateur de puissance disposé en aval de l'étage de transposition de fréquence d'émission, les deux entrées des premiers moyens de multiplication sont connectées en aval de l'étage amplificateur de puissance.

Selon un autre mode de mise en oeuvre de l'invention, les deux entrées des premiers moyens de multiplication sont connectées en amont de l'étage amplificateur de puissance, et le dispositif comporte en outre des moyens de commande aptes à désactiver l'étage amplificateur de puissance pour activer les premiers moyens de détection.

Selon un mode de réalisation de l'invention, le dispositif comporte en outre des deuxièmes moyens activables de détection, comportant
des deuxièmes moyens de génération apte à générer un signal d'étalonnage en bande de base ayant une fréquence d'étalonnage choisie dans ladite plage initiale,
des deuxièmes moyens de multiplication possédant ses deux entrées connectées en aval de l'étage de transposition de fréquence d'émission et en amont de l'étage d'amplification de puissance de façon à délivrer un signal transposé élevé au carré issu dudit signal d'étalonnage en bande de base,
des deuxièmes moyens de filtrage aptes à filtrer le signal transposé élevé au carré de façon à en éliminer les composantes radiofréquences, et
des deuxièmes moyens de mesure aptes à mesurer au moins le niveau de la composante fréquentielle du signal filtré ayant le double de ladite fréquence d'étalonnage ;
le dispositif comporte en outre des moyens de commande aptes à désactiver l'étage amplificateur de puissance et les premiers moyens de détection pour activer les deuxièmes moyens de détection.

De préférence, les premiers et deuxièmes moyens de génération sont des moyens communs, les premiers et deuxièmes de filtrage sont des moyens communs et les premiers et deuxièmes moyens de mesure sont des moyens communs.

De façon à ne pas créer d'harmonique supplémentaire, les premiers moyens de multiplication, et éventuellement les deuxièmes moyens de multiplication comportent avantageusement une cellule de Gilbert dont les transistors fonctionnent en régime linéaire.

Selon un mode de réalisation de l'invention, les premiers et éventuellement les deuxièmes moyens de mesure comportent des moyens aptes à effectuer une transformée du signal filtré dans le domaine fréquentiel et des moyens de mesure de niveau des échantillons correspondant à ladite composante fréquentielle.

Selon un mode de réalisation de l'invention, les premiers et éventuellement les deuxièmes moyens de génération sont aptes à générer plusieurs signaux d'étalonnage ayant des fréquences d'étalonnage différentes choisies dans ladite plage de fréquences initiale et les moyens de mesure associés sont aptes à mesurer les niveaux des composantes fréquentielles correspondantes.

Le dispositif comprenant généralement une voie de réception comportant un filtre passe-bas disposé en aval d'un étage de transposition de fréquences de réception, ce filtre passe-bas forme de préférence les premiers et éventuellement les deuxièmes moyens de filtrage.

Les moyens de commande sont par exemple aptes à activer les premiers moyens de détection et éventuellement les deuxièmes moyens de détection à la mise sous tension du dispositif.

Lorsque le dispositif comporte un capteur de température, les moyens de commande sont avantageusement aptes à activer les premiers moyens de détection et éventuellement les deuxièmes moyens de détection au cours de périodes d'inactivité en émission et en réception du dispositif, en particulier lors de changements de température détectés par le capteur de température.

D'autres avantage et caractéristiques de l'invention apparaîtront à l'examen de la description détaillée de modes de réalisation et de mise en oeuvre, nullement limitatifs, et des dessins annexés sur lesquels :
- la figure 1 illustre de façon schématique la structure de protocole interne d'un émetteur/récepteur sans fil selon un mode de réalisation de l'invention,
- les figures 2 et 3 illustrent plus en détail toujours de façon schématique, des exemples de structures d'un dispositif de la figure 1 ,
- les figures 4 et 5 illustrent de façon schématique un premier mode de mise en oeuvre du procédé selon l'invention,
- la figure 6 illustre schématiquement un mode de réalisation d'un multiplieur utilisé dans l'invention,
- la figure 7 illustre schématiquement et plus en détail un second mode de réalisation d'un dispositif selon l'invention,
- les figures 8 et 9 illustrent de façon schématique un deuxième mode de mise en oeuvre du procédé selon l'invention, et,
- les figures 10 et 11 illustrent de façon schématique différents cas possibles de mise en oeuvre des phases de détection du procédé selon l'invention.

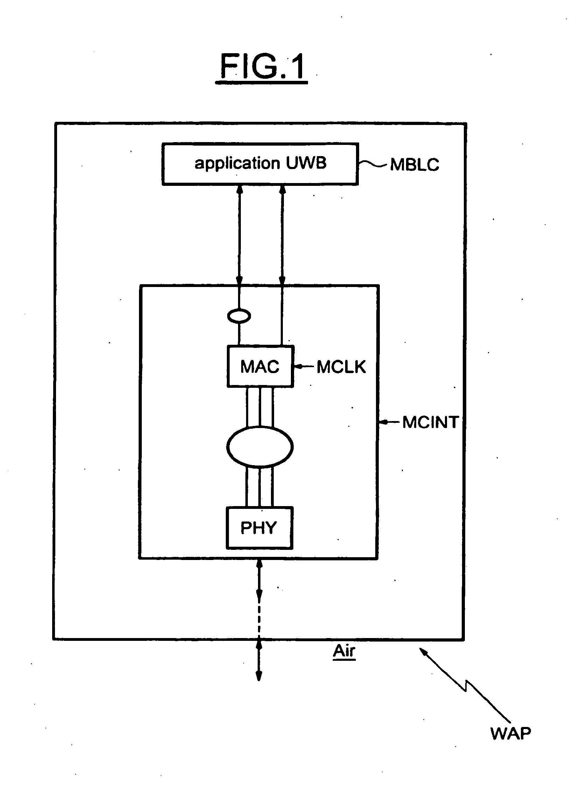

La figure 1 illustre un exemple d'un dispositif de communication sans fil ou transmetteur WAP appartenant à un système de communication non coordonné tel qu'un réseau local sans fil du type WLAN (Wireless Local Area Network) ou du type WPAN (Wireless Personal Area Network).

Un tel dispositif sans fil WAP appartient par exemple à un système de communication du type à bande ultra large basé sur une modulation à multiplexage par répartition orthogonale de fréquences (UWB OFDM).

Les protocoles WPAN-MAC ont une nature distribuée dans laquelle il n'y a aucun terminal central coordinateur ou station de base pour assigner les accès au milieu de communication. Ainsi, par opposition à un téléphone mobile cellulaire par exemple, un transmetteur WPAN a une plus grande flexibilité pour allouer les intervalles de transmission et les formats de transmission. L'allocation des ressources de communication est donc un processus distribué. L'allocation d'un intervalle de temps spécifique dans une supertrame peut être modifiée d'une supertrame à une autre. L'entité de commande est la couche WPAN-MAC des terminaux de communication. L'allocation est basée sur le débit de données requis et sur le type de service à transmettre. En outre, les ressources disponibles sont prises en compte dans le processus d'allocation. La couche MAC demande une réservation pour un intervalle de temps spécifique ou pour plusieurs intervalles de temps en fonction de ses contraintes. Ses contraintes peuvent être subdivisées en des contraintes locales telles que le débit de données à transmettre ou à recevoir et en des contraintes au niveau réseau telles que la réservation déjà effectuée pour des intervalles de temps existants.

Un exemple de protocole distribué du type WPAN-MAC est le protocole MBOA-MAC.

Le projet de norme MBOA est basé sur la technologie à Bande Ultra Large (UWB) et est prévu pour être utilisé dans la bande fréquentielle s'étendant entre 3,1 et 10,7 GHz. Des premières réalisations utilisant cette norme, fonctionnent dans la plage fréquentielle 3,1-5 GHz.

Le dispositif sans fil WAP de la figure 1 comprend une interface de communication du type UWB basée sur une modulation OFDM, cette interface étant référencée MCINT et connectée entre un bloc d'application UWB référencé MBLC et le milieu de communication (ici, l'air).

L'interface de communication MCINT comprend une couche UWB MAC synchronisée par un signal d'horloge MCLK et connectée à une couche PHY ainsi qu'au bloc d'application MBLC.

Les couches MAC et PHY sont des couches classiques et connues en soi par l'homme du métier. Pour plus de détails concernant les couches MAC et PHY de l'interface de communication MCINT, l'homme du métier peut se référer à la spécification technique de la couche MBOA PHY, version 1.0, janvier 2005, ainsi qu'à la spécification technique de la couche MBOA MAC, version 0v7, octobre 2004.

La couche MAC contrôle en particulier l'émission/réception du flux de données UWB et est incorporée par logiciel dans un processeur de commande.

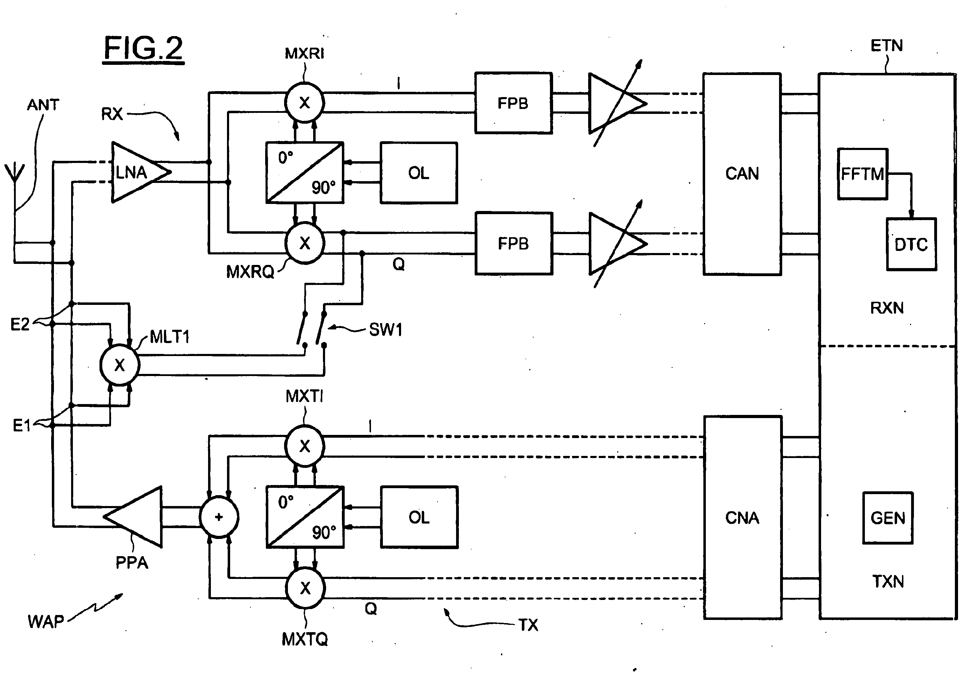

Si l'on se réfère maintenant plus particulièrement à la figure 2, l'interface de communication du dispositif WAP comprend une voie d'émission ayant une partie analogique TX et une partie numérique TXN, ainsi qu'une voie de réception ayant une partie analogique RX et une partie numérique RXN.

La voie d'émission et la voie de réception sont du type à conversion directe.

Les deux voies d'émission et de réception sont couplées ici à l'antenne ANT par un duplexeur par exemple.

Les chaînes d'émission et de réception fonctionnent ici dans un mode partagé (Half Duplex selon une dénomination anglo-saxonne habituellement utilisée) c'est-à-dire que la transmission et la réception des signaux ne se font pas de façon simultanée.

Cela étant, l'invention n'est pas limitée à un mode de fonctionnement du type « Half Duplex » mais peut également s'appliquer à un mode de fonctionnement du type « Full Duplex »selon une dénomination anglo-saxonne habituellement utilisée, c'est-à-dire avec une transmission et une réception simultanées.

La partie analogique de la voie d'émission TX comporte de façon classique deux voies, l'une en phase I et l'autre en quadrature de phase Q.

La voie d'émission TX comporte un étage de transposition de fréquence d'émission comportant ici un mélangeur MXTI disposé sur la branche I et un mélangeur MXTQ disposé sur la branche en quadrature Q.

Il convient de noter ici que l'architecture du dispositif WAP est une architecture différentielle. Naturellement, l'invention n'est pas limitée à ce type d'architecture et peut également s'appliquer à une architecture du type à entrée unique (Single Ended selon une dénomination anglo-saxonne habituellement utilisée).

Les deux mélangeurs MXTI et MXTQ reçoivent chacun un signal de transposition émis par un oscillateur local OL. Cela étant, le signal de transposition délivré au mélangeur MXTQ est déphasé de 90° par rapport au signal de transposition délivré au mélangeur MXTI.

La sortie des deux mélangeurs MXTI et MXTQ est reliée à un additionneur dont la sortie est connectée à un étage d'amplification de puissance PPA.

La sortie de l'amplificateur de puissance PPA est reliée au duplexeur d'antenne.

La partie analogique de la voie de réception RX comporte de façon classique un amplificateur faible bruit LNA dont l'entrée est connectée au duplexeur d'antenne et dont la sortie est connectée à un étage de transposition de fréquence de réception formé ici de deux mélangeurs MXRI et MXRQ respectivement disposés sur les deux branches I et Q de réception.

Là encore, le signal de transposition reçu par le mélangeur MXRQ est délivré par le signal d'oscillateur local OL et déphasé de 90° par rapport au signal de transposition délivré au mélangeur MXRI.

La sortie de chaque mélangeur est reliée à un filtre passe-bas FPB destiné à éliminer les résidus de mélanges. La sortie de chaque filtre FPB est connectée à un étage de conversion analogique numérique CAN par l'intermédiaire d'un amplificateur à gain variable.

Outre les moyens qui viennent d'être décrits, le dispositif WAP selon ce mode de réalisation de l'invention comporte des premiers moyens de multiplication, ou multiplieur, MLT1 dont les deux entrées E1 et E2 sont connectées en aval de l'étage d'amplification de puissance PPA.

On peut d'ores et déjà observer ici que de par sa configuration, le multiplieur MLT1 multiplie par lui-même le signal en entrée et délivre en sortie ce signal d'entrée élevé au carré.

La sortie du multiplieur MLT1 est connectée sur l'une des branches, ici la branche Q, de la voie de réception RX, entre le mélangeur correspondant MXRQ et le filtre passe-bas FPB. Cette connexion s'effectue par l'intermédiaire d'un interrupteur SW1, formé par exemple de transistors commandables sur leur électrode de commande. Cet interrupteur SW1 est commandé par un signal de commande émis par la couche MAC.

Bien entendu, il aurait été tout à fait possible de connecter la sortie du multiplieur MLT1 sur l'autre branche, ici la branche I, de la voie de réception.

De façon à pouvoir mettre en oeuvre une première phase de détection selon l'invention, ainsi qu'il sera explicité plus en détail ci-après, il est également prévu dans la partie numérique TXN de la voie d'émission, contenue dans l'étage numérique de traitement ETN (processeur en bande de base) des moyens de génération d'un signal d'étalonnage en bande de base, référencés GEN.

De façon classique, un symbole numérique en bande de base du type UWB-OFDM est composé de 128 sous-porteuses (correspondant de façon classique et connue aux données, au pilote, etc.). Les données transmises sont générées en calculant la transformée de Fourier inverse IFFT de 128 échantillons numériques en bande de base dans le domaine fréquentiel et en complétant le résultat avec un certain nombre d'échantillons ayant la valeur zéro.

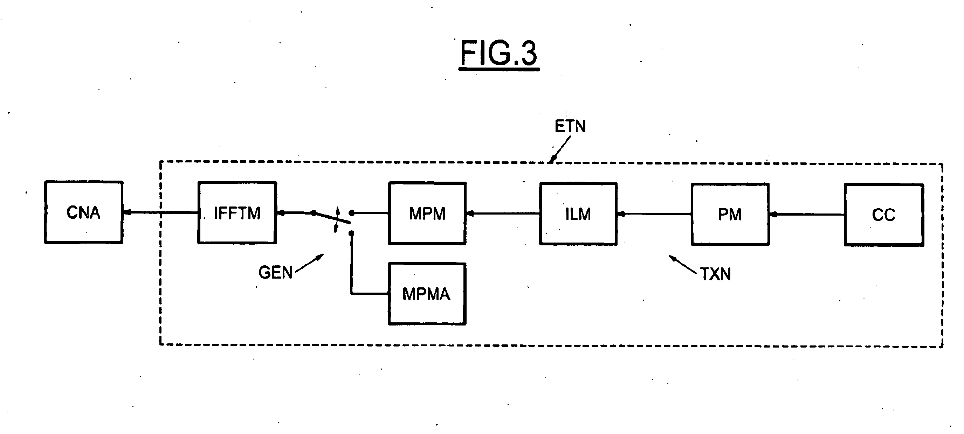

Comme illustré plus précisément sur la figure 3, la partie numérique TXN de la voie d'émission comprend un encodeur CC, par exemple un encodeur convolutionnel, recevant des données provenant de moyens de codage de source et délivrant un flux de bits à des moyens de poinçonnement (Puncturing means selon une dénomination anglo-saxonne habituellement utilisée) PM qui délivrent un flux de bits poinçonné.

Des moyens d'entrelacement ILM sont connectés à la sortie des moyens de poinçonnement PM et sont suivis par des moyens de correspondance MPM (Mapping means selon une dénomination anglo-saxonne habituellement utilisée) qui effectuent une conversion de bits en symboles, selon un schéma de modulation dépendant du type de modulation utilisée, par exemple une modulation du type BPSK ou plus généralement une modulation QAM.

Les symboles successifs délivrés par les moyens de correspondance MPM sont des symboles numériques en bande de base MB-OFDM (multibandes OFDM). Chaque symbole est un groupe contenant 128 coefficients de modulation respectivement associés à 128 sous-porteuses devant être modulées compte tenu des coefficients respectifs.

Bien entendu, un groupe de 128 échantillons est délivré sur la branche I tandis qu'un autre groupe correspondant de 128 échantillons est délivré sur la branche Q.

Ces groupes successifs de coefficients de modulation complexes numériques dans le domaine fréquentiel sont ensuite délivrés à un modulateur OFDM référencé IFFTM qui réalise un traitement de transformée de Fourier inverse de façon à associer un coefficient de modulation à une sous-porteuse et à former un symbole OFDM qui comprend 128 sous-porteuses modulées.

Les moyens appartenant à l'étage numérique en bande de base peuvent être réalisés par exemple par logiciel au sein d'un microprocesseur. Une autre possibilité peut consister à réaliser au moins certains de ces moyens, par exemple les moyens IFFTM, à l'aide de circuits intégrés spécifiques.

Les symboles dans le domaine temporel délivrés par le modulateur OFDM IFFTM sont ensuite traités dans la voie d'émission analogique après avoir été convertis dans un étage de conversion numérique analogique CNA.

Les moyens de génération GEN aptes à générer le signal d'échantillonnage peuvent être réalisés dans le cas présent par des moyens de correspondance MPMA aptes à délivrer dans le domaine fréquentiel un coefficient de modulation de référence associé à une sous-porteuse choisie (une fréquence choisie). En pratique, les moyens MPMA peuvent être réalisés par des moyens identiques aux moyens de correspondance MPM.

Ces moyens MPMA peuvent être, dans la phase de détection, connectés à l'entrée des moyens IFFTM par un commutateur également activé par un signal de commande généré par la couche de contrôle MAC.

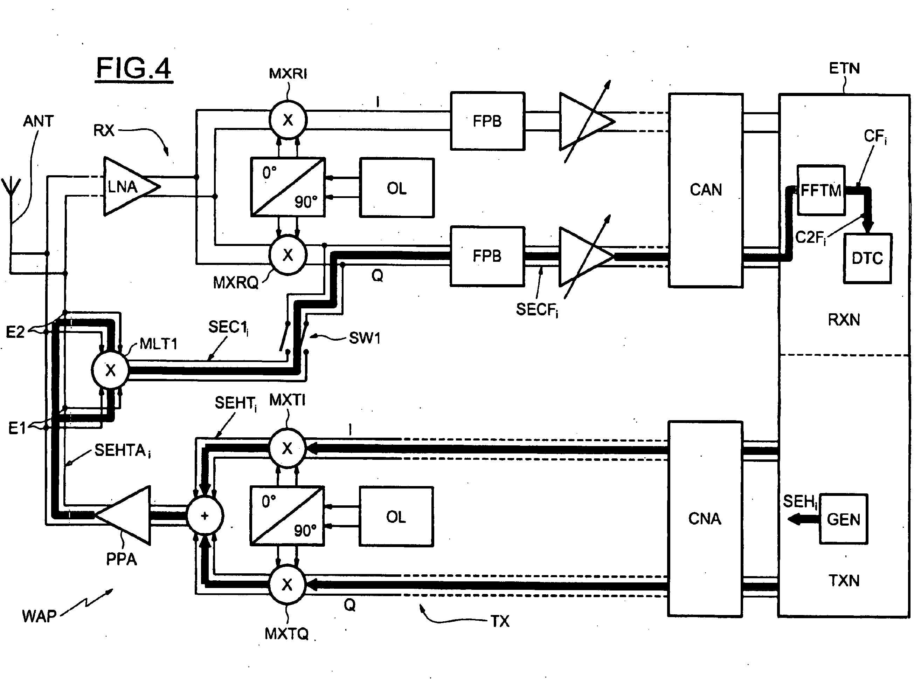

Ainsi, un signal d'échantillonnage de forme sinusoïdale (ou cosinusoïdale), référencé SEHᵢ est délivré sur la voie d'émission TX (figure 4).

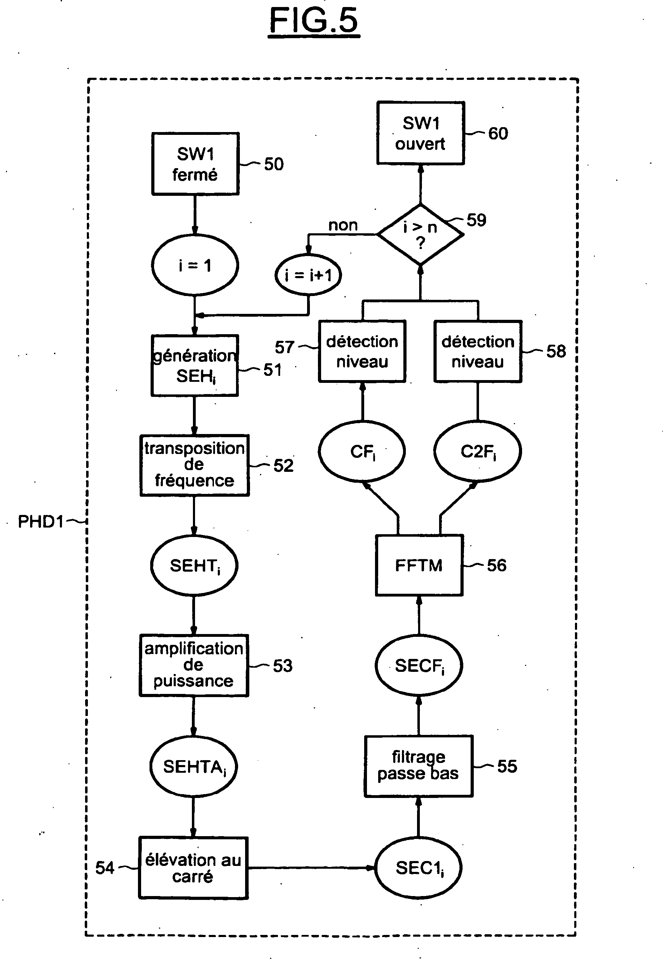

On se réfère maintenant plus particulièrement à cette figure 4 ainsi qu'à la figure 5 pour décrire les principales étapes de la phase de détection PHD1.

Le commutateur SW1 est fermé (étape 50) et le signal d'échantillonnage SEHᵢ, ayant la fréquence fᵢ, est généré (étape 51). La fréquence fᵢ du signal d'échantillonnage est choisie dans la plage de fréquence en bande de base, qui dans le cas présent s'étend entre 0 et 264 MHz.

Après transposition de fréquence (étape 52) le signal d'échantillonnage transposé SEHTᵢ est amplifié dans l'étage d'amplification de puissance PPA (étape 53) et le signal transposé amplifié SEHTAᵢ est ensuite élevé au carré dans le premier multiplieur MLT1.

A la sortie de l'amplificateur de puissance PPA, il existe par conséquent une combinaison de trois signaux sinusoïdaux correspondant respectivement au signal d'échantillonnage en bande de base converti dans le domaine radiofréquence (fréquence F+fᵢ), à la fuite de l'oscillateur local (fréquence F), ainsi qu'au signal image (fréquence F-fᵢ).

Il résulte alors des équations trigonométriques résultant de la multiplication de signaux sinusoïdaux (ou cosinusoïdaux), que le signal élevé au carré SEC1ᵢ comporte des composantes fréquentielles se situant aux alentours de deux fois la fréquence F de l'oscillateur local ainsi que des composantes fréquentielles ayant la fréquence fᵢ du signal d'échantillonnage en bande de base ainsi que la fréquence 2fᵢ.

Les composantes fréquentielles se situant aux alentours de deux fois la fréquence du signal d'oscillateur local sont des composantes qui ne sont pas gênantes puisqu'elles se situent en dehors de la bande de fréquence du signal utile et seront par conséquent filtrées. Par contre, les composantes fréquentielles ayant les fréquences fᵢ et 2fᵢ, et qui résultent d'imperfections de la voie d'émission, se situent, en fonction de la valeur de la fréquence fᵢ, dans la bande de base et peuvent par conséquent interférer avec les signaux utiles reçus sur la voie de réception.

Le signal élevé au carré SEC1ᵢ est ensuite filtré (étape 55) dans le filtre passe-bas FPB de la voie de réception de façon à éliminer les composantes radiofréquences.

Le signal filtré SECFᵢ, est ensuite, après amplification, converti dans le domaine numérique et transformé dans le domaine fréquentiel par des moyens de transformée de Fourier directe FFTM (étape 56).

Il devient alors possible de détecter le niveau de ces composantes fréquentielles CFᵢ (fréquence fᵢ) et C2Fᵢ (fréquence 2fᵢ). Ceci s'effectue dans les étapes 57 et 58 à l'aide par exemple d'un détecteur quadratique (détecteur RMS) classique DTC.

On balaye alors la plage initiale de fréquence (bande de base) en changeant la fréquence d'échantillonnage du signal d'échantillonnage généré (étape 59) et on recommence la succession des étapes qui viennent d'être décrites. En pratique, on peut choisir une dizaine de valeurs de fréquences de façon à mesurer les niveaux pour les composantes fréquentielles fᵢ ainsi que pour les composantes fréquentielles dont le produit 2fᵢ tombe également dans la bande de base.

Lorsque cette phase de détection PHD 1 est terminée, l'interrupteur SW1 est de nouveau ouvert (étape 60).

Le niveau de la composante fréquentielle CFᵢ est représentatif de la fuite d'oscillateur local. En pratique, celle-ci peut être corrigée en injectant dans le mélangeur une tension continue de décalage par exemple égale à l'opposé du niveau de tension mesuré dans le détecteur quadratique DTC.

Le niveau de la composante fréquentielle C2Fᵢ est quant à lui plus représentatif d'une erreur connue par l'homme du métier sous la dénomination anglosaxonne EVM et représentative d'une déviation par rapport à une constellation idéale. Celle-ci résulte d'un désappariement entre les branches I et Q et peut être également corrigée de façon connue.

Ainsi, l'invention permet de détecter des imperfections de la voie d'émission et ce, quel que soit bien entendu le niveau radiofréquence du signal émis, mais tout particulièrement pour des signaux faible niveau comme les signaux UWB pour lesquels une détection dans le domaine radiofréquence était difficilement réalisable de façon intégrée dans toute la bande radiofréquence du signal utile.

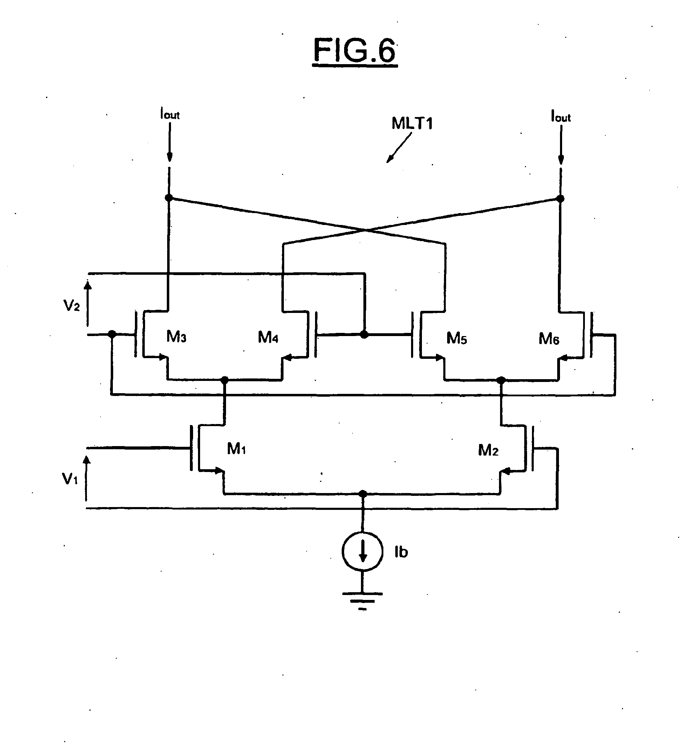

Il est particulièrement avantageux, comme illustré sur la figure 6, d'utiliser comme cellule multiplicatrice, une cellule de Gilbert réalisée en technologie CMOS, et dont les transistors fonctionnent dans le domaine linéaire. Sur la figure 6, les tensions V1 et V2 désignent les deux entrées de la cellule et la sortie différentielle formée par les collecteurs des transistors M₃ et M₅ d'une part et M₄ et M₆ d'autre part, délivre le courant Iₒᵤₜ correspondant au signal SEC1ᵢ.

Le premier étage de la cellule de Gilbert est formé de deux autres transistors MOS M₁ et M₂ polarisés par une source de courant Ib.

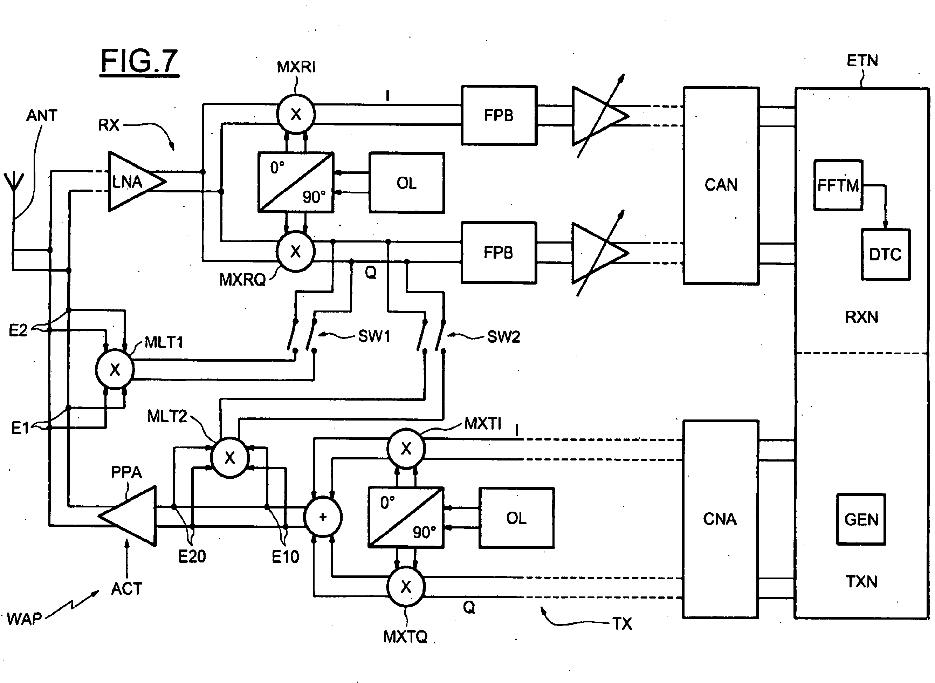

On se réfère maintenant plus particulièrement à la figure 7 pour décrire un second mode de réalisation d'un dispositif selon l'invention. Ce second mode de réalisation diffère de celui qui a été décrit en référence à la figure 4 par le fait qu'il est prévu un second multiplieur MLT2, de structure analogue à celle du premier multiplieur MLT1, mais dont les deux entrées E10 et E20 sont cette fois-ci connectées en amont de l'amplificateur de puissance PPA. La sortie du deuxième multiplieur MLT2 est également connectée en amont du filtre passe-bas FPB par l'intermédiaire d'un interrupteur SW2 également commandable par la couche MAC.

Par ailleurs, un signal de désactivation ACT de l'étage d'amplificateur de puissance PPA peut être également émis.

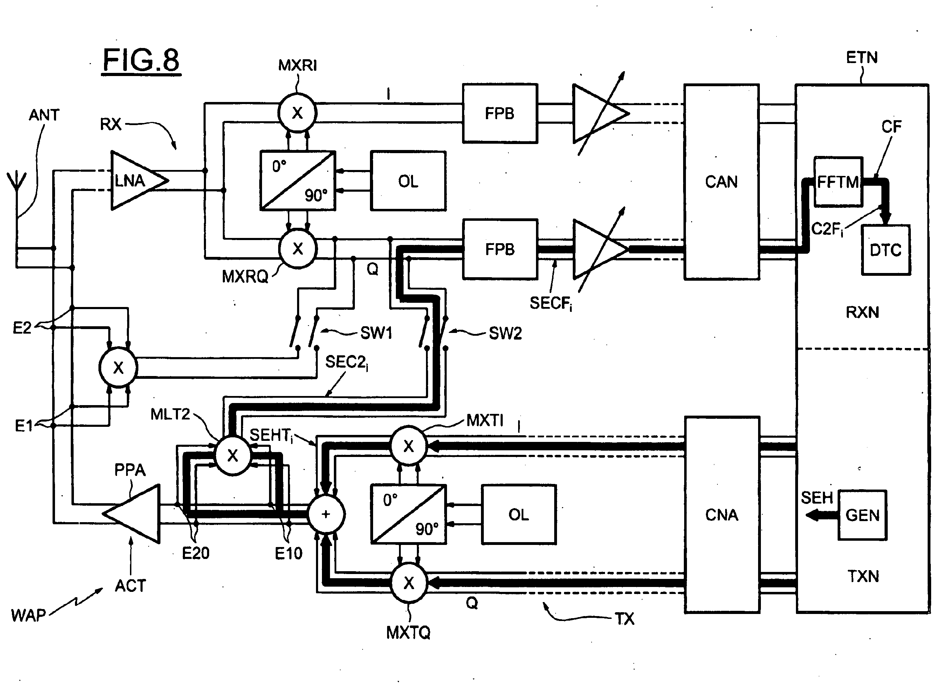

Ce mode de réalisation est particulièrement avantageux car il permet de mesurer plus précisément le niveau de la composante fréquentielle ayant la fréquence 2fᵢ. En effet, le niveau de cette composante est plus bas que le niveau de la composante fréquentielle ayant la fréquence fᵢ. Dans ces conditions, en désactivant l'amplificateur de puissance au moyen du signal ACT, on peut délivrer un signal d'échantillonnage SEHᵢ ayant un niveau beaucoup plus élevé, ce qui permet, comme illustré sur la figure 8, d'obtenir une mesure plus précise de la composante fréquentielle C2Fᵢ.

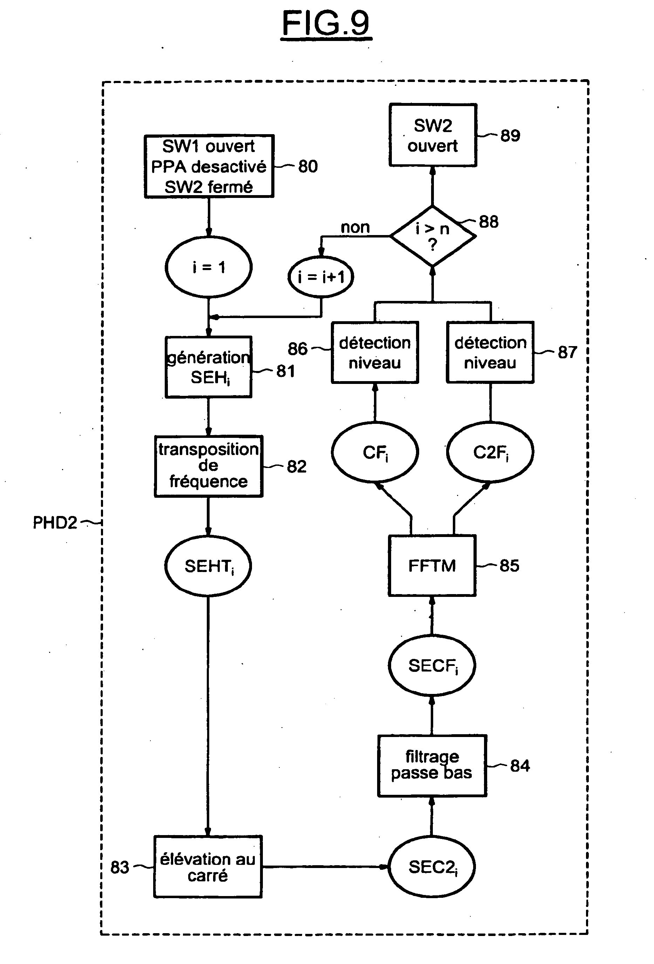

Bien entendu, cette deuxième phase de détection, qui est également illustrée sur la figure 9, permet également de mesurer le niveau de la composante fréquentielle CFᵢ ayant la fréquence fᵢ.

On voit sur la figure 9 que cette deuxième phase de détection, est analogue à la première phase de détection PHD1 1 à la différence que le signal d'échantillonnage transposé SEHTᵢ est directement élevé au carré (étape 83) pour fournir le signal élevé au carré SEC2ᵢ.

Par ailleurs, quand cette deuxième phase de détection PHD2 est activée (interrupteur SW2 fermé) la première phase de détection PHD1 n'est pas activée (interrupteur SW1 ouvert).

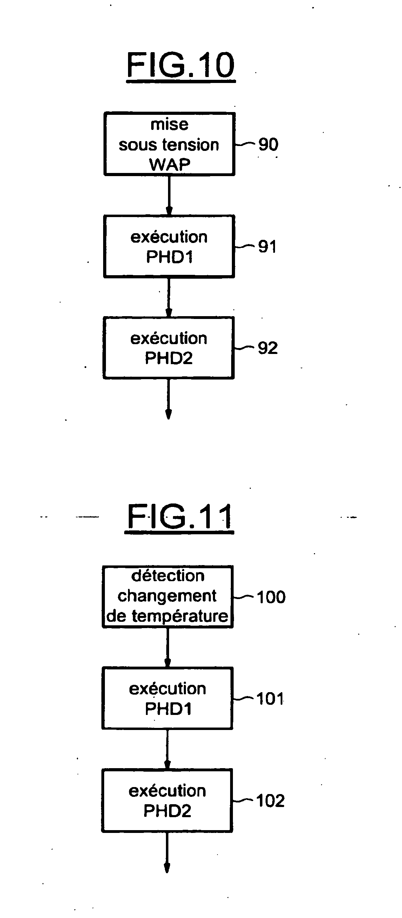

Comme illustré sur la figure 10, la première phase de détection PHD1 (étape 91) ainsi que la deuxième phase de détection PHD2 (étape 92) sont généralement utilisées à la mise sous tension du dispositif WAP (étape 90).

Cela étant, lorsque le dispositif est équipé d'un capteur de température, et que celui-ci détecte un changement de température (étape 100, figure 11) on peut alors également exécuter de façon avantageuse les deux phases de détection PHD1 et PHD2 (étapes 101 et 102) et ce au cours de périodes d'inactivité en émission et en réception du dispositif. Ces périodes d'inactivité sont connues de la couche MAC.

## Revendications

1. Procédé de détection d'imperfections de la voie d'émission d'un dispositif radiofréquence du type à conversion directe comportant un étage de transposition de fréquence d'émission apte à transposer un signal en bande de base dont la fréquence se situe dans une plage initiale de fréquences en un signal radiofréquence, procédé comprenant au moins une première phase de détection (PHD1) dans laquelle on génère (51) un signal d'étalonnage en bande de base (SEHᵢ) ayant une fréquence d'étalonnage (f) choisie dans ladite plage initiale, on multiplie par lui-même un signal d'étalonnage transposé (SEHTAᵢ) issu dudit signal d'étalonnage en bande de base et prélevé en aval de l'étage de transposition de fréquence d'émission de façon à obtenir un signal transposé élevé au carré, on filtre le signal transposé élevé au carré (SEC1ᵢ)de façon à en éliminer les composantes radiofréquences, et on mesure au moins le niveau de la composante fréquentielle (CFᵢ)du signal filtré (SECFᵢ)ayant ladite fréquence d'étalonnage (fᵢ), **caractérisé en ce que** la voie d'émission comportant un étage amplificateur de puissance (PPA) disposé en aval de l'étage de transposition de fréquence d'émission, le signal d'étalonnage transposé (SEHTAᵢ) est prélevé en aval de l'étage amplificateur de puissance et **en ce que** le procédé comporte en outre une deuxième phase de détection (PHD2), effectuée à un instant différent de la première phase de détection (PHD1), au cours de laquelle on désactive l'étage amplificateur de puissance (PPA), on génère (81) un signal d'étalonnage en bande de base ayant une fréquence d'étalonnage choisie dans ladite plage initiale, on prélève le signal d'étalonnage transposé en amont de l'étage amplificateur de puissance, on multiplie par lui-même le signal d'étalonnage transposé, on filtre le signal transposé élevé au carré (SEC2ᵢ) de façon à en éliminer les composantes radiofréquences et on mesure au moins le niveau de la composante fréquentielle (C2Fᵢ) du signal filtré ayant le double de ladite fréquence d'étalonnage.

2. Procédé selon la revendication 1, dans lequel la première phase de détection (PHD1) comporte en outre une mesure du niveau de la composante fréquentielle (C2Fᵢ) du signal filtré ayant le double de ladite fréquence d'étalonnage.

3. Procédé selon l'une des revendications précédentes, dans lequel la mesure du niveau d'une composante fréquentielle du signal filtré comporte une transformée du signal filtré dans le domaine fréquentiel (FFTM) et une mesure de niveau des échantillons correspondant à ladite composante fréquentielle.

4. Procédé selon l'une des revendications précédentes, dans lequel dans chaque phase de détection on génère plusieurs signaux d'étalonnage (SEHᵢ) ayant des fréquences d'étalonnage différentes choisies dans ladite plage de fréquences initiale et on mesure les niveaux des composantes fréquentielles correspondantes.

5. Procédé selon l'une des revendications précédentes, dans lequel chaque signal d'étalonnage (SEHᵢ) est un signal de type sinusoïdal.

6. Procédé selon l'une des revendications précédentes, dans lequel le dispositif comporte également une voie de réception comportant un filtre passe bas (FPB) disposé en aval d'un étage de transposition de fréquence de réception, et on filtre le signal transposé élevé au carré dans ledit filtre passe bas de la voie de réception.

7. Procédé selon l'une des revendications précédentes, dans lequel on effectue chaque phase de détection à la mise sous tension du dispositif (90).

8. Procédé selon l'une des revendications précédentes, dans lequel on effectue chaque phase de détection au cours de périodes d'inactivités en émission et en réception du dispositif, en particulier lors de changements de température (100).

9. Dispositif radiofréquence du type à conversion directe, comportant un étage de transposition de fréquence d'émission apte à transposer un signal en bande de base dont la fréquence se situe dans une plage initiale de fréquences en un signal radiofréquence, **caractérisé par le fait qu'**il comprend au moins des premiers moyens activables de détection comportant des premiers moyens de génération (GEN) apte à générer un signal d'étalonnage (SEHᵢ)en bande de base ayant une fréquence d'étalonnage choisie dans ladite plage initiale, des premiers moyens de multiplication (MLT1) possédant ses deux entrées connectées en aval de l'étage de transposition de fréquence d'émission (MXTI, MXTQ) de façon à délivrer un signal transposé élevé au carré issu dudit signal d'étalonnage en bande de base, des premiers moyens de filtrage (FPB) aptes à filtrer le signal transposé élevé au carré de façon à en éliminer les composantes radiofréquences, et des premiers moyens de mesure (FFTM, DTC) aptes à mesurer au moins le niveau de la composante fréquentielle du signal filtré ayant ladite fréquence d'étalonnage, **caractérisé en ce que** la voie d'émission comporte un étage amplificateur de puissance (PPA) disposé en aval de l'étage de transposition de fréquence d'émission, et les deux entrées (E1, E2) des premiers moyens de multiplication sont connectées en aval de l'étage amplificateur de puissance (PPA) et **en ce que** le dispositif comporte en outre des deuxièmes moyens activables de détection, comportant des deuxièmes moyens de génération (GEN) aptes à générer un signal d'étalonnage en bande de base ayant une fréquence d'étalonnage choisie dans ladite plage initiale, des deuxièmes moyens de multiplication (MLT2) possédant ses deux entrées connectées en aval de l'étage de transposition de fréquence d'émission et en amont de l'étage d'amplification de puissance de façon à délivrer un signal transposé élevé au carré issu dudit signal d'étalonnage en bande de base, des deuxièmes moyens de filtrage (FPB) aptes à filtrer le signal transposé élevé au carré de façon à en éliminer les composantes radiofréquences, et des deuxièmes moyens de mesure (FFTM, DTC) aptes à mesurer au moins le niveau de la composante fréquentielle du signal filtré ayant le double de ladite fréquence d'étalonnage, et le dispositif comporte en outre des moyens de commande aptes à désactiver l'étage amplificateur de puissance (PPA) et les premiers moyens de détection pour activer les deuxièmes moyens de détection.

10. Dispositif selon la revendication 9, dans lequel les premiers moyens de mesure (FFTM, DTC) sont aptes en outre à mesurer le niveau de la composante fréquentielle du signal filtré ayant le double de ladite fréquence d'étalonnage.

11. Dispositif selon la revendication 9 ou 10, dans lequel les premiers et deuxièmes moyens de génération sont des moyens communs (GEN), les premiers et deuxièmes de filtrage sont des moyens communs (FPB) et les premiers et deuxièmes moyens de mesure sont des moyens communs (FFTM, DTC).

12. Dispositif selon l'une des revendications 9 à 11, dans lequel les premiers moyens de multiplication (MLT1), et éventuellement les deuxièmes moyens de multiplication (MLT2) comportent une cellule de Gilbert dont les transistors fonctionnent en régime linéaire.

13. Dispositif selon l'une des revendications 9 à 12, dans lequel les premiers et éventuellement les deuxièmes moyens de mesure comportent des moyens (FFTM) aptes à effectuer une transformée du signal filtré dans le domaine fréquentiel et des moyens de mesure de niveau (DTC) des échantillons correspondant à ladite composante fréquentielle.

14. Dispositif selon l'une des revendications 9 à 13, dans lequel les premiers et éventuellement les deuxièmes moyens de génération (GEN) sont aptes à générer plusieurs signaux d'étalonnage ayant des fréquences d'étalonnage différentes choisies dans ladite plage de fréquences initiale et les moyens de mesure associés sont aptes à mesurer les niveaux des composantes fréquentielles correspondantes.

15. Dispositif selon l'une des revendications 9 à 14, dans lequel chaque signal d'étalonnage est un signal de type sinusoïdal.

16. Dispositif selon l'une des revendications 9 à 15, comprenant également une voie de réception comportant un filtre passe bas (FPB) disposé en aval d'un étage de transposition de fréquence de réception et formant les premiers et éventuellement les deuxièmes moyens de filtrage.

17. Dispositif selon l'une des revendications 9 à 16, dans lequel les moyens de commande (MAC) sont aptes à activer les premiers moyens de détection et éventuellement les deuxièmes moyens de détection à la mise sous tension du dispositif.

18. Dispositif selon l'une des revendications 9 à 17, comportant en outre un capteur de température et dans lequel les moyens de commande (MAC) sont aptes à activer les premiers moyens de détection et éventuellement les deuxièmes moyens de détection au cours de périodes d'inactivités en émission et en réception du dispositif, en particulier lors de changements de température détectés par le capteur de température.

## Claims

1. Method of detecting imperfections of the transmit path of a radiofrequency device of the direct conversion type comprising a transmit frequency transposition stage able to transpose a baseband signal whose frequency lies in an initial span of frequencies into a radiofrequency signal, method comprising at least one first phase of detection (PHD1) in which a baseband calibration signal (SEHᵢ) having a calibration frequency (f) chosen from the said initial span is generated (51), a transposed calibration signal (SEHTAᵢ) emanating from the said baseband calibration signal and tapped off downstream of the transmit frequency transposition stage is multiplied by itself so as to obtain a squared transposed signal, the squared transposed signal (SEC1ᵢ) is filtered so as to eliminate its radiofrequency components, and at least the level of the frequency component (CFᵢ) of the filtered signal (SECFᵢ) having the said calibration frequency (fᵢ) is measured, **characterized in that**, the transmit path comprising a power amplifier stage (PPA) disposed downstream of the transmit frequency transposition stage, the transposed sampling signal (SEHTAᵢ) is tapped off downstream of the power amplifier stage and **in that** the method furthermore comprises a second phase of detection (PHD2), performed at a different instant from the first detection phase (PHD1), in the course of which the power amplifier stage (PPA) is deactivated, a baseband calibration signal having a calibration frequency chosen from the said initial span is generated (81), the transposed sampling signal is tapped off upstream of the power amplifier stage, the transposed sampling signal is multiplied by itself, the squared transposed signal (SEC2ᵢ) is filtered so as to eliminate its radiofrequency components and at least the level of the frequency component (C2Fᵢ) of the filtered signal having twice the said calibration frequency is measured.

2. Method according to Claim 1, in which the first detection phase (PHD1) furthermore comprises a measurement of the level of the frequency component (C2Fᵢ) of the filtered signal having twice the said calibration frequency.

3. Method according to either of the preceding claims, in which the measurement of the level of a frequency component of the filtered signal comprises a transform of the filtered signal in the frequency domain (FFTM) and a measurement of the level of the samples corresponding to the said frequency component.

4. Method according to one of the preceding claims, in which in each detection phase several calibration signals (SEHᵢ) having different calibration frequencies chosen from the said initial span of frequencies are generated and the levels of the corresponding frequency components are measured.

5. Method according to one of the preceding claims, in which each calibration signal (SEHᵢ) is a signal of sinusoidal type.

6. Method according to one of the preceding claims, in which the device also comprises a receive path comprising a low-pass filter (FPB) disposed downstream of a receive frequency transposition stage, and the squared transposed signal is filtered in the said low-pass filter of the receive path.

7. Method according to one of the preceding claims, in which each detection phase is performed upon power-up of the device (90).

8. Method according to one of the preceding claims, in which each detection phase is performed in the course of periods of transmit and receive inactivities of the device, in particular upon changes of temperature (100).

9. Radiofrequency device of the direct conversion type, comprising a transmit frequency transposition stage able to transpose a baseband signal whose frequency lies in an initial span of frequencies into a radiofrequency signal, **characterized in that** it comprises at least first activatable means of detection comprising first means of generation (GEN) able to generate a baseband calibration signal (SEHᵢ) having a calibration frequency chosen from the said initial span, first means of multiplication (MLT1) possessing its two inputs connected downstream of the transmit frequency transposition stage (MXTI, MXTQ) so as to deliver a squared transposed signal emanating from the said baseband calibration signal, first means of filtering (FPB) able to filter the squared transposed signal so as to eliminate its radiofrequency components, and first means of measurement (FFTM, DTC) able to measure at least the level of the frequency component of the filtered signal having the said calibration frequency, **characterized in that** the transmit path comprises a power amplifier stage (PPA) disposed downstream of the transmit frequency transposition stage, and the two inputs (E1, E2) of the first multiplication means are connected downstream of the power amplifier stage (PPA), and **in that** the device furthermore comprises second activatable means of detection, comprising second means of generation (GEN) able to generate a baseband calibration signal having a calibration frequency chosen from the said initial span, second means of multiplication (MLT2) possessing its two inputs connected downstream of the transmit frequency transposition stage and upstream of the power amplifier stage so as to deliver a squared transposed signal emanating from the said baseband calibration signal, second means of filtering (FPB) able to filter the squared transposed signal so as to eliminate its radiofrequency components, and second means of measurement (FFTM, DTC) able to measure at least the level of the frequency component of the filtered signal having twice the said calibration frequency, and the device furthermore comprises means of control able to deactivate the power amplifier stage (PPA) and the first means of detection so as to activate the second means of detection.

10. Device according to Claim 9, in which the first measurement means (FFTM, DTC) are able furthermore to measure the level of the frequency component of the filtered signal having twice the said calibration frequency.

11. Device according to Claim 9 or 10, in which the first and second means of generation are common means (GEN), the first and second means of filtering are common means (FPB) and the first and second means of measurement are common means (FFTM, DTC).

12. Device according to one of Claims 9 to 11, in which the first means of multiplication (MLT1), and possibly the second means of multiplication (MLT2) comprise a Gilbert cell whose transistors operate in the linear regime.

13. Device according to one of Claims 9 to 12, in which the first and possibly the second means of measurement comprise means (FFTM) able to perform a transform of the filtered signal in the frequency domain and means of measurement of level (DTC) of the samples corresponding to the said frequency component.

14. Device according to one of Claims 9 to 13, in which the first and possibly the second means of generation (GEN) are able to generate several calibration signals having different calibration frequencies chosen from the said initial span of frequencies and the associated means of measurement are able to measure the levels of the corresponding frequency components.

15. Device according to one of Claims 9 to 14, in which each calibration signal is a signal of sinusoidal type.

16. Device according to one of Claims 9 to 15, also comprising a receive path comprising a low-pass filter (FPB) disposed downstream of a receive frequency transposition stage and forming the first and possibly the second means of filtering.

17. Device according to one of Claims 9 to 16, in which the control means (MAC) are able to activate the first detection means and possibly the second detection means upon power-up of the device.

18. Device according to one of Claims 9 to 17, furthermore comprising a temperature sensor and in which the control means (MAC) are able to activate the first detection means and possibly the second detection means in the course of periods of transmit and receive inactivities of the device, in particular upon changes of temperature that are detected by the temperature sensor.

## Patentansprüche

1. Verfahren zur Erfassung von Störstellen des Sendekanals einer Hochfrequenzvorrichtung vom Typ mit Direktumwandlung, die eine Sendefrequenz-Umsetzungsstufe aufweist, welche ein Signal im Basisband, dessen Frequenz sich in einem Anfangsfrequenzbereich befindet, in ein Hochfrequenzsignal umsetzen kann, wobei das Verfahren mindestens eine erste Erfassungsphase (PHD1) enthält, in der ein Kalibriersignal (SEHᵢ) im Basisband erzeugt wird (51), das eine im Anfangsbereich gewählte Kalibrierfrequenz (f) hat, ein umgesetztes Kalibriersignal (SEHTAᵢ), das vom Kalibriersignal im Basisband stammt und hinter der Sendefrequenz-Umsetzungsstufe entnommen wird, mit sich selbst multipliziert wird, um ein quadriertes umgesetztes Signal zu erhalten, das quadrierte umgesetzte Signal (SEC1ᵢ) gefiltert wird, um daraus die Hochfrequenzkomponenten zu entfernen, und mindestens der Pegel der Frequenzkomponente (CFᵢ) des gefilterten Signals (SECFᵢ) gemessen wird, die die Kalibrierfrequenz (fᵢ) hat, **dadurch gekennzeichnet, dass**, da der Sendekanal eine Leistungsverstärkungsstufe (PPA) aufweist, die hinter der Sendefrequenz-Umsetzungsstufe angeordnet ist, das umgesetzte Kalibriersignal (SEHTAᵢ) hinter der Leistungsverstärkungsstufe entnommen wird, und dass das Verfahren außerdem eine zweite Erfassungsphase (PHD2) aufweist, die zu einem anderen Zeitpunkt als die erste Erfassungsphase (PHD1) durchgeführt wird, während der die Leistungsverstärkungsstufe (PPA) deaktiviert wird, ein Kalibriersignal im Basisband erzeugt wird (81), das eine im Anfangsbereich ausgewählte Kalibrierfrequenz hat, das umgesetzte Kalibriersignal vor der Leistungsverstärkungsstufe entnommen wird, das umgesetzte Kalibriersignal mit sich selbst multipliziert wird, das quadrierte umgesetzte Signal (SEC2ᵢ) gefiltert wird, um daraus die Hochfrequenzkomponenten zu entfernen, und mindestens der Pegel der Frequenzkomponente (C2Fᵢ) des gefilterten Signals gemessen wird, die die doppelte Kalibrierfrequenz hat.

2. Verfahren nach Anspruch 1, bei dem die erste Erfassungsphase (PHD1) außerdem eine Messung des Pegels der Frequenzkomponente (C2Fᵢ) des gefilterten Signals aufweist, die die doppelte Kalibrierfrequenz hat.

3. Verfahren nach einem der vorhergehenden Ansprüche, bei dem die Messung des Pegels einer Frequenzkomponente des gefilterten Signals eine Transformation des gefilterten Signals im Frequenzbereich (FFTM) und eine Pegelmessung der Tastproben aufweist, die der Frequenzkomponente entsprechen.

4. Verfahren nach einem der vorhergehenden Ansprüche, bei dem in jeder Erfassungsphase mehrere Kalibriersignale (SEHᵢ) erzeugt werden, die unterschiedliche Kalibrierfrequenzen haben, welche im Anfangsfrequenzbereich ausgewählt werden, und die Pegel der entsprechenden Frequenzkomponenten gemessen werden.

5. Verfahren nach einem der vorhergehenden Ansprüche, bei dem jedes Kalibriersignal (SEHᵢ) ein Signal vom Sinustyp ist.

6. Verfahren nach einem der vorhergehenden Ansprüche, bei dem die Vorrichtung ebenfalls einen Empfangskanal aufweist, der ein Tiefpassfilter (FPB) aufweist, das hinter einer Empfangsfrequenz-Umsetzungsstufe angeordnet ist, und das quadrierte umgesetzte Signal im Tiefpassfilter des Empfangskanals gefiltert wird.

7. Verfahren nach einem der vorhergehenden Ansprüche, bei dem jede Erfassungsphase beim Unterspannungsetzen der Vorrichtung (90) durchgeführt wird.

8. Verfahren nach einem der vorhergehenden Ansprüche, bei dem jede Erfassungsphase während Sende- und Empfangs-Inaktivitätsperioden der Vorrichtung durchgeführt wird, insbesondere bei Temperaturänderungen (100).

9. Hochfrequenzvorrichtung vom Typ mit Direktumwandlung, die eine Sendefrequenz-Umsetzungsstufe aufweist, die ein Signal im Basisband, dessen Frequenz sich in einem Anfangsfrequenzbereich befindet, in ein Hochfrequenzsignal umsetzen kann, **dadurch gekennzeichnet, dass** sie mindestens erste aktivierbare Erfassungseinrichtungen, die erste Erzeugungseinrichtungen (GEN) aufweisen, welche ein Kalibriersignal (SEHᵢ) im Basisband erzeugen können, das eine im Anfangsbereich ausgewählte Kalibrierfrequenz hat, erste Multiplikationseinrichtungen (MLT1), deren beide Eingänge hinter der Sendefrequenz-Umsetzungsstufe (MXT1, MXTQ) verbunden sind, um ein quadriertes umgesetztes Signal zu liefern, das von dem Kalibriersignal im Basisband stammt, erste Filtereinrichtungen (FPB), die das quadrierte umgesetzte Signal filtern können, um daraus die Hochfrequenzkomponenten zu entfernen, und erste Messeinrichtungen (FFTM, DTC) enthält, die mindestens den Pegel der Frequenzkomponente des gefilterten Signals, die die Kalibrierfrequenz hat, messen können, **dadurch gekennzeichnet, dass** der Sendekanal eine Leistungsverstärkungsstufe (PPA) aufweist, die hinter der Sendefrequenz-Umsetzungsstufe angeordnet ist, und die zwei Eingänge (E1, E2) der ersten Multiplikationseinrichtungen hinter der Leistungsverstärkungsstufe (PPA) verbunden sind, und dass die Vorrichtung außerdem zweite aktivierbare Erfassungseinrichtungen, die zweite Erzeugungseinrichtungen (GEN) aufweisen, welche ein Kalibriersignal im Basisband erzeugen können, das eine im Anfangsbereich ausgewählte Kalibrierfrequenz hat, zweite Multiplikationseinrichtungen (MLT2), deren zwei Eingänge hinter der Sendefrequenz-Umsetzungsstufe und vor der Leistungsverstärkungsstufe verbunden sind, um ein quadriertes umgesetztes Signal zu liefern, das von dem Kalibriersignal im Basisband stammt, zweite Filtereinrichtungen (FPB), die das quadrierte umgesetzte Signal filtern können, um daraus die Hochfrequenzkomponenten zu entfernen, und zweite Messeinrichtungen (FFTM, DTC) aufweist, die mindestens den Pegel der Frequenzkomponente des gefilterten Signals, die die doppelte Kalibrierfrequenz hat, messen können, und die Vorrichtung außerdem Steuereinrichtungen aufweist, die die Leistungsverstärkungsstufe (PPA) und die ersten Erfassungseinrichtungen deaktivieren können, um die zweiten Erfassungseinrichtungen zu aktivieren.

10. Vorrichtung nach Anspruch 9, bei der die ersten Messeinrichtungen (FFTM, DTC) außerdem den Pegel der Frequenzkomponente des gefilterten Signals messen können, die die doppelte Kalibrierfrequenz hat.

11. Vorrichtung nach Anspruch 9 oder 10, bei der die ersten und zweiten Erzeugungseinrichtungen gemeinsame Einrichtungen (GEN) sind, die ersten und zweiten Filtereinrichtungen gemeinsame Einrichtungen (FPB) sind, und die ersten und zweiten Messeinrichtungen gemeinsame Einrichtungen (FFTM, DTC) sind.

12. Vorrichtung nach einem der Ansprüche 9 bis 11, bei der die ersten Multiplikationseinrichtungen (MLT1) und ggf. die zweiten Multiplikationseinrichtungen (MLT2) eine Gilbert-Zelle aufweisen, deren Transistoren im linearen Betrieb arbeiten.

13. Vorrichtung nach einem der Ansprüche 9 bis 12, bei der die ersten und ggf. die zweiten Messeinrichtungen Einrichtungen (FFTM), die eine Transformation des gefilterten Signals im Frequenzbereich durchführen können, und Pegelmesseinrichtungen (DTC) der Tastproben aufweisen, die der Frequenzkomponente entsprechen.

14. Vorrichtung nach einem der Ansprüche 9 bis 13, bei der die ersten und ggf. die zweiten Erzeugungseinrichtungen (GEN) mehrere Kalibriersignale erzeugen können, die unterschiedliche Kalibrierfrequenzen haben, die im Anfangsfrequenzbereich ausgewählt werden, und die zugeordneten Messeinrichtungen die Pegel der entsprechenden Frequenzkomponenten messen können.

15. Vorrichtung nach einem der Ansprüche 9 bis 14, bei der jedes Kalibriersignal ein Signal vom Sinustyp ist.

16. Vorrichtung nach einem der Ansprüche 9 bis 15, die ebenfalls einen Empfangskanal enthält, der ein Tiefpassfilter (FPB) aufweist, das hinter einer Empfangsfrequenz-Umsetzungsstufe angeordnet ist und die ersten und ggf. die zweiten Filtereinrichtungen bildet.

17. Vorrichtung nach einem der Ansprüche 9 bis 16, bei der die Steuereinrichtungen (MAC) die ersten Erfassungseinrichtungen und ggf. die zweiten Erfassungseinrichtungen beim Unterspannungsetzen der Vorrichtung aktivieren können.

18. Vorrichtung nach einem der Ansprüche 9 bis 17, die außerdem einen Temperaturmessfühler aufweist, und bei der die Steuereinrichtungen (MAC) die ersten Erfassungseinrichtungen und ggf. die zweiten Erfassungseinrichtungen während Sende- und Empfangs-Inaktivitätsperioden der Vorrichtung, insbesondere bei Temperaturänderungen, aktivieren können, die vom Temperaturmessfühler erfasst werden.
